# EUROPEAN PATENT APPLICATION

(11) **EP 3 214 463 A1**
(43) Date of publication of application: **06.09.2017**
(21) Application number: 16206550.2
(22) Date of filing: 23.12.2016
(51) Int. Cl.: G01S 17/02, G01S 7/481, H02G 15/013

(54) **OPTICAL ELECTRONIC DEVICE**

(30) Priority: 03.03.2016 JP 2016041601
(71) Applicant: Omron Corporation, Kyoto 600-8530 (JP)
(72) Inventor: MIZUSAKI, Hiroyuki, Kyoto-shi, Kyoto 600-8530 (JP); SUGIMOTO, Makoto, Kyoto-shi, Kyoto 600-8530 (JP); NAKASHIMA, Hirotaka, Kyoto-shi, Kyoto 600-8530 (JP); OHASHI, Kazuyuki, Yokohama-shi, Kanagawa 222-0033 (JP)
(74) Representative: Addiss, John William

(57) **Abstract**

An optical electronic device (1) comprises: a casing (10) having an external surface provided with an opening (16); a cable (50) inserted through the opening (16); a bush (60) attached to the cable (50); and a resin sealing portion (80). The bush (60) is brought into close contact with the cable (50) and the casing (10) to seal a gap between the cable (50) and the casing (10). The resin sealing portion (80) is provided locally inside the casing (10) to cover an internal surface of a portion of the casing (10) surrounding the opening (16) and a surface of a portion of the cable (50) drawn from the opening (16) into the casing (10).

## Description

### BACKGROUND OF THE INVENTION

### Field of the Invention

The present invention relates to an optical electronic device including an optical component and an electronic component, and particularly to an optical electronic device having a cable drawn out of a casing.

### Description of the Background Art

In general, in an electronic device, a structure is adopted in which a power supply cable for supplying electric power, a signal cable for connection to an external terminal, etc. are drawn out of a casing. In that case, the casing is provided with an opening and the cable is disposed to pass through the opening. In such a configuration, in order to ensure resistance to an environment, a sealing structure is generally applied in a vicinity of the opening for sealing the casing's internal space from outside.

For example, Japanese Patent Laying-Open No. 2007-271512 discloses a photoelectric sensor including a sealing structure configured such that a casing at a portion surrounding an opening has an external surface provided with a cylindrical boss and before a cable is inserted into the casing a cylindrical rubber bush is previously attached to the cable, and when the cable is inserted into the casing a portion of the cable having the rubber bush attached thereto is press-fitted inside the boss and the opening.

When this sealing structure is adopted, the rubber bush is sandwiched by the casing and the cable in the radial direction of the cable, and the compressed rubber bush prevents a gap from being formed between the casing and the cable and thus seals the casing's internal space from outside.

However, even when the above sealing structure is adopted, it cannot be said that a sufficient resistance to an environment is ensured in a relatively severe environment. For example, in an environment where temperature significantly varies over time and a cutting oil or a similar oil, a significantly corrosive agent etc. are used in large amounts, even when the above sealing structure is adopted, there is a possibility that the rubber bush itself may degrade or the cable's sheath may degrade or the like, and it is thus difficult to ensure sufficient resistance to the environment over a long period of time.

When an electronic device's resistance to an environment is impaired by such degradation of the rubber bush, sheath etc., there is a possibility that moisture may enter the casing and a short may be caused in an electrical circuit, which would cause a failure of the electronic device. Furthermore, in an optical electronic device including an optical component like the above described photoelectric sensor, when moisture enters the casing, it condenses on a surface of the optical component and would also induce an erroneous operation.

In particular, when the sheath is degraded, capillarity immediately allows moisture to enter the casing through the cable, which may lead to significantly impairing the product's lifetime in a relatively severe environment as described above.

Furthermore, in some type of electronic device, in order to ensure resistance to an environment, a structure where a casing's internal space in which an electronic component is accommodated is sealed with a resin material is adopted. However, in the above described optical electronic device, the resin material may interrupt or attenuate light or the like, and it is thus significantly difficult to adopt the structure.

### SUMMARY OF THE INVENTION

The present invention has been made in view of the above problems and an object thereof is to provide an optical electronic device particularly excellent in resistance to an environment.

The optical electronic device based on the present invention includes a casing, an optical component, an electronic component, a cable, a bush, and a resin sealing portion. The casing has an external surface provided with an opening. The optical component is assembled to the casing, and the electronic component is accommodated in the casing. The cable is disposed through the opening to have one end drawn into the casing and electrically connected to the electronic component and the other end drawn out of the casing. The bush has a cylindrical shape and is attached to the cable, and is brought into close contact with the cable and the casing to seal a gap between the cable and the casing. The resin sealing portion is provided locally inside the casing to cover an internal surface of a portion of the casing surrounding the opening and a surface of a portion of the cable drawn from the opening into the casing.

By this configuration, inside the casing, a boundary of the cable and the casing is locally covered with the resin sealing portion. Accordingly, in addition to a sealing structure using the bush, a sealing structure using that resin sealing portion is added, and a dual sealing structure can be obtained and significantly improved sealing performance can be achieved. Note that the bush is any bush, such as of rubber and plastic, that can seal a gap between the cable and the casing.

In the optical electronic device based on the present invention, it is preferable that a cable passing chamber be provided inside a portion of the casing corresponding to the opening to allow the portion of the cable drawn from the opening into the casing to be passed therethrough and thus disposed therein, and in that case, it is preferable that the cable passing chamber be filled with the resin sealing portion.

This configuration facilitates providing the resin sealing portion locally in the casing.

In the optical electronic device based on the present invention, an inner end of the bush closer to the one end of the cable may be inserted into the opening, and in that case, it is preferable that the resin sealing portion further cover a surface of the inner end of the bush.

This configuration ensures that a boundary of the bush and the casing and a boundary of the bush and the cable are covered with the resin sealing portion. High sealing performance can thus be obtained.

The optical electronic device based on the present invention may further comprise a fixing member having an annular shape and assembled to the casing to fix the bush to the casing, and in that case, it is preferable that the bush be composed of rubber.

This configuration can enhance close contact of the casing and the bush and thus provide high sealing performance.

In the optical electronic device based on the present invention, the opening may be provided at a bottom surface of a recess provided at the external surface of the casing, and in that case, it is preferable that the fixing member be fitted in the recess to cooperate with the cable to sandwich at least a portion of the bush in a radial direction of the cable.

This configuration can enhance close contact of the cable and the bush and thus provide high sealing performance.

In the optical electronic device based on the present invention, it is preferable that the fixing member cooperate with the bottom surface of the recess to further sandwich at least a portion of the bush in a longitudinal direction of the cable.

This configuration can enhance close contact of the casing and cable and the bush and thus provide high sealing performance.

In the optical electronic device based on the present invention, the cable may have a core wire including an electrically conductive line and a sheath covering the core wire, and in that case, the core wire at a portion thereof on the side of the one end of the cable may be exposed without being covered with the sheath. In that case, it is preferable that an end of the sheath closer to the one end of the cable be covered with the resin sealing portion.

This configuration allows a boundary of the cable's core wire and sheath to be covered with the resin sealing portion. If the sheath should degrade, a moisture penetration path formed to pass through the cable can be interrupted by the resin sealing portion, and high sealing performance can thus be obtained.

In the optical electronic device based on the present invention, the sheath may be composed of fluororesin.

This configuration allows particularly high oil resistance and hence high resistance to an environment.

In the optical electronic device based on the present invention, the bush may be composed of fluororubber.

This configuration allows particularly high oil resistance and can thus achieve high resistance to an environment.

In the optical electronic device based on the present invention, the resin sealing portion may be composed of epoxy resin.

This configuration can enhance close contact of the resin sealing portion and the casing and cable and can thus achieve high resistance to an environment.

The present invention can thus provide an optical electronic device particularly excellent in resistance to an environment.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a perspective view of a photoelectric sensor in an embodiment of the present invention, as seen from a front side.
Fig. 2 is a perspective view of the photoelectric sensor shown in Fig. 1, as seen from a back side.
Fig. 3 is a schematic cross section of the photoelectric sensor shown in Fig. 1.
Fig. 4 is an exploded perspective view of a main portion of the photoelectric sensor shown in Fig. 1.
Fig. 5 is an enlarged schematic cross section of a cable connection unit of the photoelectric sensor shown in Fig. 1.

### DESCRIPTION OF THE PREFERRED EMBODIMENTS

An embodiment of the present invention will now be described hereinafter in detail with reference to drawings. An embodiment indicated hereinafter will be described by indicating as an example a case where the present invention is applied to a reflection type photoelectric sensor serving as an optical electronic device. In the following embodiment, identical or common components are identically denoted in the figures and will not be described repeatedly.

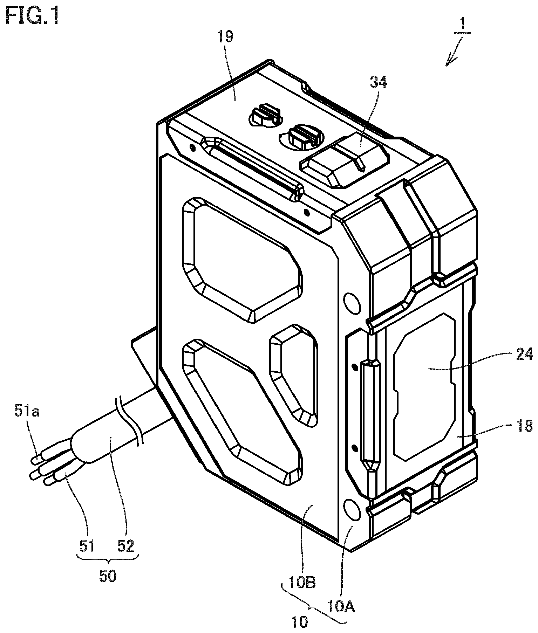

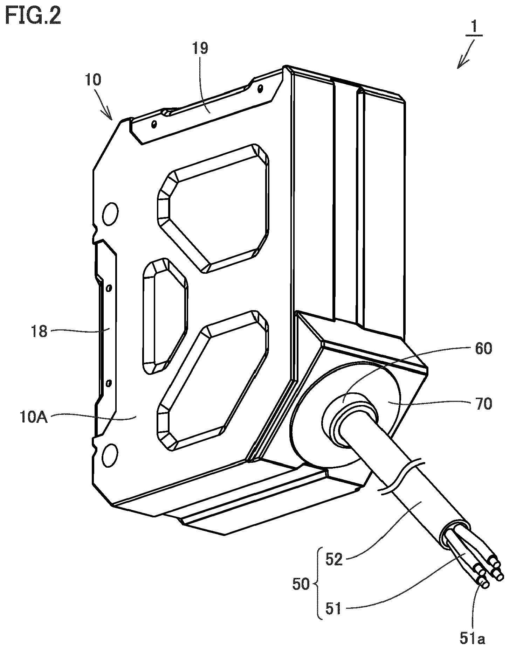

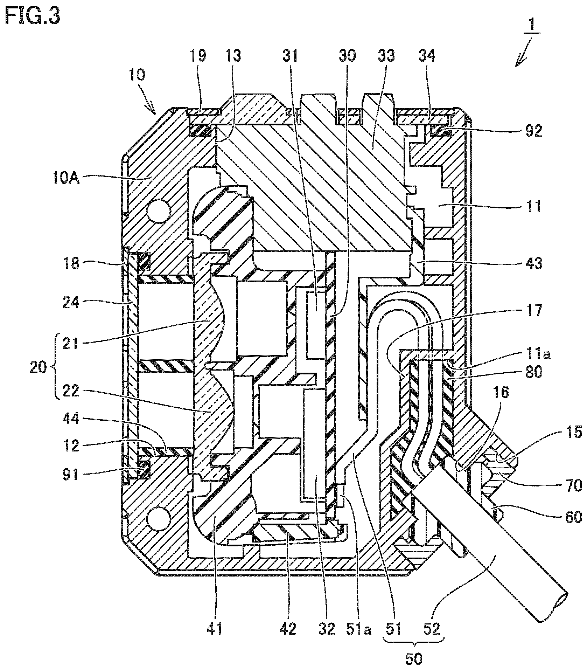

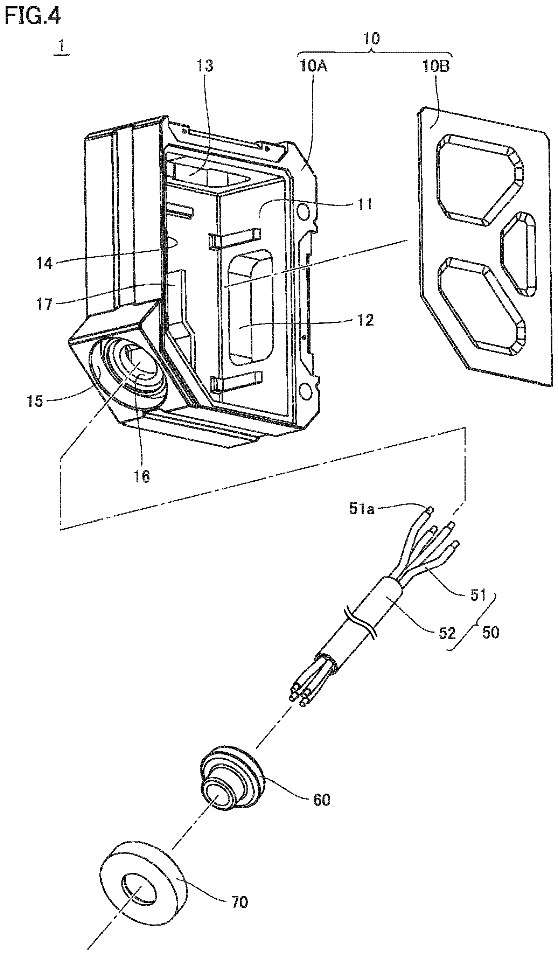

Fig. 1 is a perspective view of a photoelectric sensor in an embodiment of the present invention, as seen from a front side, and Fig. 2 is a perspective view of the photoelectric sensor shown in Fig. 1, as seen from a back side. Furthermore, Fig. 3 is a schematic cross section of the photoelectric sensor shown in Fig. 1, and Fig. 4 is an exploded perspective view of a main portion of the photoelectric sensor shown in Fig. 1. Initially, with reference to Fig. 1 to Fig. 4, a schematic configuration of a photoelectric sensor 1 in the present embodiment will be described.

As shown in Fig. 1 to Fig. 4, photoelectric sensor 1 is generally shaped substantially in the form of a rectangular parallelepiped, and mainly includes a casing 10, a lens member 20 and a transmissive plate 24 serving as a main optical component, a light projecting and receiving circuit board 30 which has a light projecting element 31 and a light receiving element 32 mounted thereon and serves as a main electronic component, a display and operation unit 33, a displaying transmissive member 34, various brackets 41-43, a cable 50, a bush 60, and a fixing member 70.

Casing 10 includes a body case 10A in the form of a box and a body cover 10B in the form of a flat plate. Body case 10A mainly configures the front surface, rear surface, upper surface, lower surface, and right side surface of photoelectric sensor 1, and body cover 10B configures a portion of the left side surface of photoelectric sensor 1. Note that the front surface is a surface where transmissive plate 24 is assembled, and the rear surface is a surface opposite to the front surface. Furthermore, the upper surface is a surface where display and operation unit 33 is assembled, and the lower surface is a surface opposite to the upper surface.

Body case 10A and body cover 10B are metallic members for example, and are suitably members made of stainless steel. Body case 10A is produced by metal injection molding (MIM) for example, and body cover 10B is produced by press-working a metal plate for example.

As shown in Fig. 4, a side surface opening 14 is provided at a portion corresponding to a left side surface of body case 10A, and body cover 10B is assembled to cover side surface opening 14. Body cover 10B for example has its peripheral edge entirely laser-welded and thus fixed to body case 10A.

Thus, an accommodation space 11 is formed inside casing 10 composed of body case 10A and body cover 10B, and various internal components such as lens member 20, light projecting and receiving circuit board 30, display and operation unit 33, brackets 41-43 etc. are accommodated in accommodation space 11. Note that side surface opening 14 is an opening for assembling the above described various internal components to an interior of body case 10A. Note the photoelectric sensor can be established without display and operation unit 33.

As shown in Fig. 3 and Fig. 4, a front surface opening 12 is provided at a prescribed position through the front surface of body case 10A. As shown in Fig. 1 and Fig. 3, front surface opening 12 is covered with transmissive plate 24, and a cover 18 for the transmissive plate is assembled to body case 10A to further cover transmissive plate 24.

For example, cover 18 for the transmissive plate is a metallic member having a window at that prescribed position and is suitably a member made of stainless steel. Cover 18 for the transmissive plate is produced by press-working a metal plate for example.

An O ring 91 is disposed between transmissive plate 24 and body case 10A, and in that condition when cover 18 for the transmissive plate is assembled to body case 10A a gap between transmissive plate 24 and body case 10A is filled with O ring 91. Thus, at a portion of body case 10A provided with front surface opening 12, accommodation space 11 located inside casing 10 is sealed from a space external to casing 10. Note that cover 18 for the transmissive plate is fixed to body case 10A by laser welding, for example.

As shown in Fig. 3 and Fig. 4, an upper surface opening 13 is provided at a prescribed position through the upper surface of body case 10A. As shown in Fig. 1 and Fig. 3, display and operation unit 33 is located in accommodation space 11 at a portion which faces upper surface opening 13, and display and operation unit 33 and upper surface opening 13 are covered with displaying transmissive member 34. Furthermore, a cover 19 for the display and operation unit is assembled to body case 10A to cover displaying transmissive member 34.

For example, cover 19 for the display and operation unit is a metallic member having a window and a hole at that prescribed position and is suitably a member made of stainless steel. Cover 19 for the display and operation unit is produced by press-working a metal plate for example.

An O ring 92 is disposed between displaying transmissive member 34 and body case 10A, and in that condition when cover 19 for the display and operation unit is assembled to body case 10A a gap between displaying transmissive member 34 and body case 10A is filled with O ring 92. Thus, at a portion of body case 10A provided with upper surface opening 13, accommodation space 11 located inside casing 10 is sealed from a space external to casing 10. Note that cover 19 for the display and operation unit is fixed to body case 10A by laser welding, for example.

Display and operation unit 33 includes a display unit composed of a light emitting diode (LED) etc., an operation unit including a sensitivity adjusting volume, an operation selector switch, etc., and a display and operation circuit board on which various electronic components configuring the display unit and the operation unit are mounted. The display and operation circuit board is electrically connected to light projecting and receiving circuit board 30 via a wiring etc. (not shown). Note that displaying transmissive member 34 is a member for diffusing light emitted from the display unit so that the light is externally, visually observable.

As shown in Fig. 3, in accommodation space 11 serving as a space in casing 10, at a position behind front surface opening 12, lens member 20 is disposed, and furthermore, at a position behind lens member 20, light projecting and receiving circuit board 30 is disposed. Furthermore, in front surface opening 12 at a portion located between lens member 20 and transmissive plate 24, a spacer 44 is disposed for maintaining a distance therebetween.

Light projecting and receiving circuit board 30 has a major surface facing lens member 20 and having an upper portion with light projecting element 31 which is for example a semiconductor light emitting diode, a semiconductor laser diode (LD), etc. mounted, and a lower portion with light receiving element 32 which is for example a semiconductor photodiode (PD) etc. mounted.

A portion of lens member 20 opposite to light projecting element 31 is provided with a light projecting lens 21, and a portion of lens member 20 opposite to light receiving element 32 is provided with a light receiving lens 22.

Thus, in photoelectric sensor 1, light emitted from light projecting element 31 is radiated to a space outside photoelectric sensor 1 via light projecting lens 21 and transmissive plate 24, and a reflection of the light is sensed by light receiving element 32 via transmissive plate 24 and light receiving lens 22.

Note that lens member 20, light projecting and receiving circuit board 30, and display and operation unit 33 are held in accommodation space 11 by various brackets 41-43 etc. assembled to an interior of casing 10.

Light projecting and receiving circuit board 30 has front and back surfaces with an electrically conductive pattern formed thereon, and has, in addition to light projecting element 31 and light receiving element 32, various electronic components mounted thereon. Thus, light projecting and receiving circuit board 30 is provided with various electrical circuits. The electrical circuits include a drive circuit for driving light projecting element 31, a signal processing circuit which photoelectrically converts the light that is sensed by light receiving element 32 into a prescribed output signal, a power supply circuit which receives externally supplied power, converts it to a prescribed power supply specification, and externally outputs it, etc. for example.

Light projecting and receiving circuit board 30 at a prescribed position closer to a lower end thereof is provided with a land (not shown) to which an electrically conductive line 51a included in a core wire 51 of cable 50 described later is connected. The land and electrically conductive line 51a of cable 50 are connected together for example by soldering, and cable 50 is thus electrically connected to the above described various electrical circuits. Accordingly, photoelectric sensor 1 receives electric power, provides an output to an external terminal, etc. through cable 50.

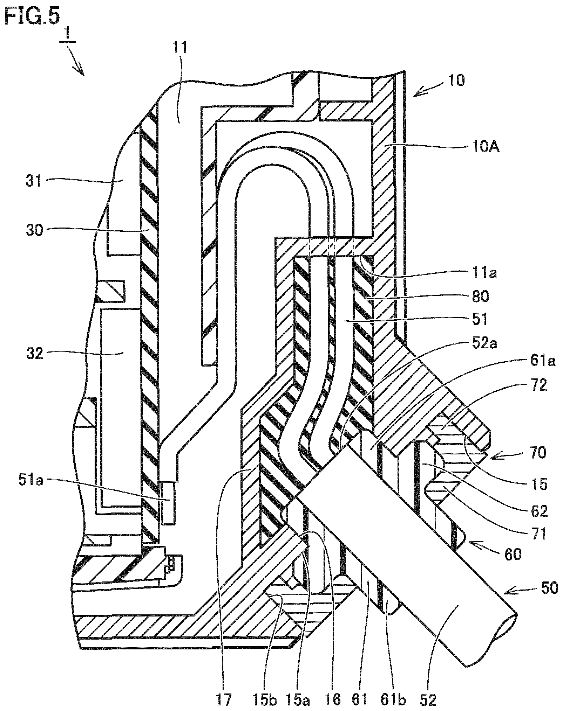

Fig. 5 is an enlarged schematic cross section of a cable connection unit of the photoelectric sensor shown in Fig. 1. Hereinafter, reference will be made to Fig. 5, and Fig. 1 to Fig. 4 to describe in detail a configuration of the cable connection unit of photoelectric sensor 1 in the present embodiment.

As shown in Fig. 1 to Fig. 5, cable 50 is a composite cable composed of core wire 51 including electrically conductive line 51a and a sheath 52 which covers core wire 51. In the present embodiment, cable 50 is a composite cable which has four core wires 51 bundled together and covered with a single sheath 52. Note that cable 50 may further include a shielding material covering core wire 51 and also covered with sheath 52. Note that sheath 52 is made of resin for example, and more suitably, composed of any one of polyvinyl chloride (PVC) resin, polyurethane (PUR) resin and fluororesin.

As shown in Fig. 3 to Fig. 5, a recess 15 which is circular in a plan view is provided at an external surface of body case 10A configuring a position on the side of a rear and lower surface of casing 10. Recess 15 has a bottom surface 15a provided with a cable inserting opening 16 in communication with accommodation space 11 provided inside casing 10 and a space external to casing 10, and cable inserting opening 16 also has a circular shape in a plan view. Furthermore, bottom surface 15a of recess 15 is provided with an annular groove 15b surrounding cable inserting opening 16.

Cable 50 is disposed through cable inserting opening 16 of body case 10A, and has one end drawn into casing 10 and electrically connected to light projecting and receiving circuit board 30 and the other end drawn out of casing 10.

Note that cable 50 has one end having sheath 52 removed to expose core wire 51, and furthermore, a portion of core wire 51 connected to the land provided on light projecting and receiving circuit board 30 also has a covering material removed to expose electrically conductive line 51a.

At a prescribed position on cable 50, a cylindrical bush 60 is attached. Bush 60 is for example a rubber member, and is suitably composed of any one of nitrile rubber (NBR), hydrogenated nitrile rubber (HNBR), and fluororubber. Note that the bush is not limited to being formed of rubber, and a variety of types that can seal a gap between cable 50 and casing 10, such as a plastic bush, can be used. Bush 60 has a cylindrical portion 61 covering sheath 52 of cable 50 and an annular protrusion 62 protruding outward from cylindrical portion 61.

More specifically, bush 60 is such that an inner end 61a of cylindrical portion 61 closer to accommodation space 11 of casing 10 (i.e., an end closer to one end of cable 50) is inserted through cable inserting opening 16 of body case 10A together with cable 50 and the entirety of annular protrusion 62 and a portion of an outer end 61b of cylindrical portion 61 are located in recess 15 of body case 10A.

Furthermore, in recess 15 of body case 10A, fixing member 70 in an annular form is fitted to thus fix cable 50 to casing 10. Fixing member 70 is a metallic member for example, and is suitably composed of brass. Fixing member 70 has a base 71 in the form of an annular plate and an annular projection 72 erected from an outer edge of base 71.

More specifically, fixing member 70 is fitted in recess 15 of body case 10A to cover bottom surface 15a of recess 15, the entirety of annular protrusion 62 of bush 60, and a portion of outer end 61b of cylindrical portion 61. Annular projection 72 has a tip fitted into annular groove 15b of bottom surface 15a of recess 15.

Note that bush 60 is attached to cable 50, and in that condition, together with cable 50, press-fitted into cable inserting opening 16, and furthermore, fixing member 70 is press-fitted into recess 15 to compress bush 60.

Thus fixing member 70 cooperates with cable 50 to sandwich the entirety of annular protrusion 62 of bush 60 and a portion of outer end 61b of cylindrical portion 61 in the radial direction of cable 50, and cooperates with bottom surface 15a of recess 15 to sandwich annular protrusion 62 of bush 60 in the longitudinal direction of cable 50. Thus at these portions bush 60 closely contacts cable 50 and body case 10A and thus at those portions accommodation space 11 located inside casing 10 is sealed from a space external to casing 10.

In addition, photoelectric sensor 1 in the present embodiment is provided with a partition wall 17 at a position which is included in accommodation space 11 of casing 10 and is also opposite to cable inserting opening 16. Partition wall 17 is erected from an internal surface of body case 10A. Partition wall 17 and a wall portion of body case 10A in a vicinity of a portion provided with cable inserting opening 16 define a cable passing chamber 11a allowing cable 50 to have a prescribed portion passing therethrough and thus disposed therein.

In cable passing chamber 11a is disposed a portion of cable 50 drawn from cable inserting opening 16 into casing 10. More specifically, in cable passing chamber 11a, an end 52a of sheath 52 closer to one end of cable 50 is disposed, and cable passing chamber 11a thus has accommodated therein a portion of cable 50 corresponding to end 52a, and a portion of core wire 51 drawn out of that end.

Cable passing chamber 11a where cable 50 has a prescribed portion passed therethrough and thus disposed therein is filled with a resin sealing portion 80. Resin sealing portion 80 is composed of a resin material which has high weatherability after it sets, and for example, epoxy resin, urethane resin, a type of epoxy resin or urethane resin etc. which foams after it is introduced into the cable passing chamber can be suitably used. Note that resin sealing portion 80 can be formed for example as follows: after cable 50 is fixed in body case 10A, a resin material in the form of a liquid is poured into cable passing chamber 11a and set therein.

By filling cable passing chamber 11a with resin sealing portion 80, an internal surface of a portion of body case 10A surrounding cable inserting opening 16 and a surface of a portion of cable 50 drawn from cable inserting opening 16 into body case 10A are continuously covered with resin sealing portion 80.

Thus, in addition to the sealing structure using bush 60 and fixing member 70, a boundary of cable 50 and casing 10 is covered with resin sealing portion 80 at a position in casing 10 inner than a portion provided with bush 60. Accordingly, at that portion, a portion of accommodation space 11 excluding cable passing chamber 11a is sealed from a space external to casing 10.

Furthermore, in the present embodiment, bush 60 is disposed such that cylindrical portion 61 has inner end 61a to face cable passing chamber 11a, and resin sealing portion 80 continuously covers a surface of inner end 61 a of bush 60, an internal surface of a portion of body case 10A adjacent to inner end 61a of bush 60, and a surface of cable 50.

This ensures that a boundary of bush 60 and body case 10A and a boundary of bush 60 and cable 50 are covered with resin sealing portion 80, and thus further ensures that a portion of accommodation space 11 excluding cable passing chamber 11a is sealed from a space external to casing 10.

In addition, in the present embodiment, end 52a of sheath 52 closer to one end of cable 50 is disposed to face cable passing chamber 11a, and a surface of end 52a of sheath 52 and a surface of core wire 51 are also continuously covered with resin sealing portion 80.

Thus, a boundary of core wire 51 of cable 50 and sheath 52 is covered with resin sealing portion 80, and if sheath 52 should degrade, a moisture penetration path through cable 50 is interrupted by resin sealing portion 80. This further ensures that a portion of accommodation space 11 excluding cable passing chamber 11a is sealed from a space external to casing 10.

Thus, photoelectric sensor 1 in the present embodiment includes, in addition to the sealing structure using bush 60 and fixing member 70, a sealing structure using resin sealing portion 80 locally formed at a portion at which cable 50 is drawn from cable inserting opening 16 into casing 10, and photoelectric sensor 1 in the present embodiment thus has higher sealing performance than conventional.

Thus, even in a relatively severe environment, sufficient resistance to an environment can be ensured over a long period of time. This can effectively suppress penetration of moisture into the casing, and can thus prevent short-circuit caused in an electrical circuit, condensation on a surface of an optical component, etc.

Furthermore, as has been described above, resin sealing portion 80 is locally provided and thus it is not necessary to seal accommodation space 11 of casing 10 in which an optical component is accommodated with a resin material entirely, and light passing through casing 10 is neither interrupted nor attenuated. Thus, a photoelectric sensor which sufficiently satisfies various optical performance can be provided.

Thus, photoelectric sensor 1 in the present embodiment, for example even in a relatively severe environment where temperature significantly varies over time and a cutting oil or a similar oil, a significantly corrosive agent etc. are used in large amounts, ensures sufficient resistance to the environment over a long period of time and can thus be a photoelectric sensor excellent in resistance to the environment, in particular.

Furthermore, photoelectric sensor 1 in the present embodiment is configured such that partition wall 17 is provided inside casing 10 to provide cable passing chamber 11a serving as a resin reservoir, and simply by managing an amount of a resin material to be introduced and confirming whether cable 50 is immersed in the introduced resin material, photoelectric sensor 1 can obtain the above described high sealing performance and its productivity can also be improved.

Furthermore, photoelectric sensor 1 in the present embodiment is configured such that a portion of cable 50 drawn from cable inserting opening 16 into casing 10 is covered with resin sealing portion 80, and cable 50 is thus held by not only bush 60 but also resin sealing portion 80, which can more effectively prevent cable 50 from escaping when it is pulled.

Note that, in photoelectric sensor 1 in the above described present embodiment, when fluororesin is selected as a material for sheath 52 of cable 50, fluororubber is selected as a material for bush 60 and epoxy resin is selected as a material for resin sealing portion 80, significantly high oil resistance can be ensured. Accordingly, it is preferable to use this material combination in a photoelectric sensor used in an environment where oil such as a cutting oil is used in a large amount.

While in the embodiment of the present invention described above a case is indicated by way of example which is configured such that a cable passing chamber is provided inside a casing, the cable passing chamber is not necessarily provided and a resin sealing portion may simply be provided locally around a portion of a cable drawn from the cable inserting opening into the casing.

Furthermore, while in the embodiment of the present invention described above a case has been described by way of example which is configured such that an end of a sheath of a cable is covered with a resin sealing portion, this is not a requirement and the end of the sheath may be exposed from the resin sealing portion. In that case, a moisture penetration path through the cable cannot be interrupted, however, penetration of moisture through a boundary of the bush and the cable and a boundary of the bush and the casing is more effectively prevented than conventional. Furthermore, the sheath itself can also be composed of a member which has high weatherability to thereby prevent penetration of moisture through the cable.

Furthermore, while in the embodiment of the present invention described above a case has been described by way of example in which the bush is inserted not only in a recess provided in the casing but also even into a cable inserting opening and the bush is also provided with an annular protrusion so that the bush is also sandwiched between a fixing member and the casing in the longitudinal direction of the cable, this is not a requirement and the bush may simply be sandwiched only by the fixing member and the cable.

Furthermore, while in the embodiment of the present invention described above a case has been described by way of example in which the casing has an external surface provided with a recess and the recess has a bottom surface provided with a cable inserting opening, the cable inserting opening is not necessarily provided at the recess and the cable inserting opening may be provided at an external surface of the casing that is not provided with the recess. In that case, the fixing member may be fixed to the casing without being fitted in the recess, or the fixing member may not be introduced at all. In any case, the bush brought into close contact with the casing and the cable to thereby seal a gap between the cable and the casing, suffices.

Furthermore, while in the embodiment of the present invention described above a case has been described by way of example in which the present invention is applied to a reflection type photoelectric sensor, the present invention is not limited thereto in to what it is applied, and the present invention is of course also applicable to a photoelectric sensor in a different form, an optical electronic device other than the photoelectric sensor and the like.

While the present invention has been described in embodiments, it should be understood that the embodiments disclosed herein are illustrative and non-restrictive in any respect. The scope of the present invention is defined by the terms of the claims, and is intended to include any modifications within the meaning and scope equivalent to the terms of the claims.

## Claims

1. An optical electronic device comprising:
a casing (10) having an external surface provided with an opening (16);
an optical component (20) assembled to the casing (10);
an electronic component (30) accommodated in the casing (10);
a cable (50) disposed through the opening (16) to have one end drawn into the casing (10) and electrically connected to the electronic component (30) and the other end drawn out of the casing (10);
a bush (60) having a cylindrical shape and attached to the cable (50), and brought into close contact with the cable (50) and the casing (10) to seal a gap between the cable (50) and the casing (10); and
a resin sealing portion (80) provided locally inside the casing (10) to cover an internal surface of a portion of the casing (10) surrounding the opening (16) and a surface of a portion of the cable (50) drawn from the opening (16) into the casing (10).

2. The optical electronic device according to claim 1, wherein:
a cable passing chamber (11a) allowing the portion of the cable (50) drawn from the opening (16) into the casing (10) to be passed therethrough and thus disposed therein is provided inside a portion of the casing (10) corresponding to the opening (16); and
the cable passing chamber (11a) is filled with the resin sealing portion (80).

3. The optical electronic device according to claim 1 or 2, wherein:
an inner end (61a) of the bush (60) closer to the one end of the cable (50) is inserted into the opening (16); and
the resin sealing portion (80) further covers a surface of the inner end (61a) of the bush (60).

4. The optical electronic device according to any one of claims 1 to 3, further comprising a fixing member (70) having an annular shape and assembled to the casing (10) to fix the bush (60) to the casing (10), wherein the bush (60) is composed of rubber.

5. The optical electronic device according to claim 4, wherein:
the opening (16) is provided at a bottom surface (15a) of a recess (15) provided at the external surface of the casing (10); and
the fixing member (70) is fitted in the recess (15) to cooperate with the cable (50) to sandwich at least a portion of the bush (60) in a radial direction of the cable (50).

6. The optical electronic device according to claim 5, wherein the fixing member (70) cooperates with the bottom surface (15a) of the recess (15) to further sandwich at least a portion of the bush (60) in a longitudinal direction of the cable (50).

7. The optical electronic device according to any one of claims 1 to 6, wherein:
the cable (50) has a core wire (51) including an electrically conductive line and a sheath (52) covering the core wire (51);
the core wire (51) at a portion thereof on a side of the one end of the cable (50) is exposed without being covered with the sheath (52); and
an end (52a) of the sheath (52) closer to the one end of the cable (50) is covered with the resin sealing portion (80).

8. The optical electronic device according to claim 7, wherein the sheath (52) is composed of fluororesin.

9. The optical electronic device according to any one of claims 1 to 8, wherein the bush (60) is composed of fluororubber.

10. The optical electronic device according to any one of claims 1 to 9, wherein the resin sealing portion (80) is composed of epoxy resin.
